# EUROPÄISCHE PATENTSCHRIFT

(11) **EP 0 491 063 B1**
(45) Veröffentlichungstag und Bekanntmachung des Hinweises auf die Patenterteilung: **21.06.1995**
(21) Anmeldenummer: 90124441.8
(22) Anmeldetag: 17.12.1990
(51) Int. Cl.: H03H 21/00

(54) **Adaptives Balancefilter**
Adaptive balance filter
Filtre d'équilibrage adaptatif

(43) Veröffentlichungstag der Anmeldung: 24.06.1992
(73) Patentinhaber: SIEMENS AKTIENGESELLSCHAFT, 80333 München (DE)
(72) Erfinder: Gazsi, Lajos, Dr., W-4000 Düsseldorf (DE)

(56) Entgegenhaltungen:
- WO-A-82/03145
- GB-A- 2 126 851
- 1988 IEEE INTERNATIONAL SYMPOSIUM ON CIRCUITS AND SYSTEMS ; Espoo (FINLAND) ,7-9/6/1988; S.J.POOLE u.a. :"A CMOS subscriber line processing circuitincluding adaptive balance"

## Beschreibung

Die Erfindung betrifft ein adaptives Balancefilter.

Ein wesentliches Problem bei digitalen Vermittlungsanlagen stellt der Duplexbetrieb, d.h. das gleichzeitige Senden und Empfangen, mit hohen Datenraten über vorhandene Zweidrahtleitungen dar. Schwierigkeiten bereitet dabei ein Übersprechen von dem analogen Sendeweg auf den analogen Empfangsweg vor allem bei der Verzweigung der Zweidrahtleitungen in Sende- und Empfangswege. Anstelle der vormals üblichen analogen Gabelschaltungstechnik hat sich insbesondere bei öffentlichen Netzen mit Reichweiten um 8 km eine allgemein als digitale Echounterdrückung bezeichnete Methode durchgesetzt. Dabei wird davon ausgegangen, daß das Übersprechen durch eine Übertragungsfunktion des Echopfads entsprechend einem Filter zwischen Sende- und Empfangsweg beschrieben werden kann. Zur Echounterdrückung wird nun ein sogenanntes Balancefilter zwischen Sende- und Empfangsweg geschaltet, daß eine zum Echopfad inverse Übertragungsfunktion aufweist.

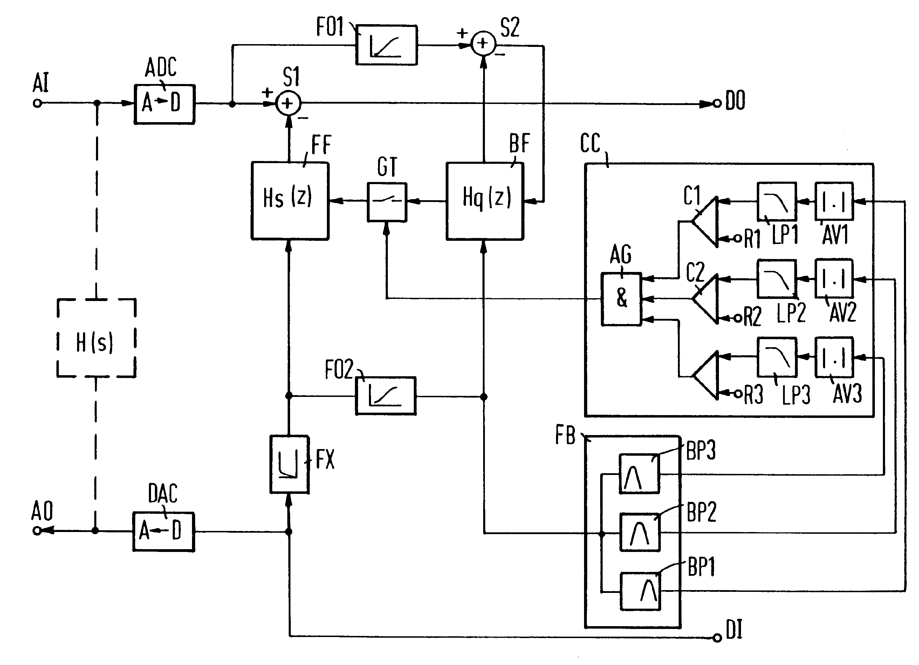

Ein derartiges Balancefilter ist beispielsweise aus S. J. Poole, G. Surace, B. Singh, N. P. Dyer, A CMOS Subscriber Line Audio Processing Circuit Including Adaptive Balance, International Symposium on Circuits and Systems, Helsinki June 7-9,1988, S. 1931-1934, insbesondere FIG 4 bekannt. Dieses Balancefilter ist als adaptives Filter ausgeführt, d. h. das Balancefilter paßt sich unterschiedlichen bzw. sich ändernden Übertragungsfunktionen des Echopfads an. Zum Einstellen der inversen Übertragungsfunktion werden die Koeffizienten des Balancefilters dahingehend geändert, daß ein nach bestimmten Kriterien gebildetes Fehlersignal minimiert wird. Das bekannte adaptive Balancefilter besteht unter anderem aus einem adaptiven Filter (Background Filter), das anhand des Fehlersignals die optimalen Filterkoeffizienten ermittelt, und aus einem Schattenfilter (Foreground Filter) mit festen Filterkoeffizienten, wobei die Filterkoeffizienten des Schattenfilters unter einer bestimmten Bedingung gleich den Filterkoeffizienten des adaptiven Filters gesetzt werden. Die Bedingung für die Übernahme der Filterkoeffizienten ist hierbei, daß über einen gegebenen längeren Beobachtungszeitraum der Fehler des adaptiven Filters kleiner ist als der Fehler des Schattenfilters. Beim Fehlen eines Sendesignals nämlich ist ein Adaptieren nahezu unmöglich und die Übertragungsfunktion des adaptiven Filters ist daher mit einem großen Fehler behaftet. Daher wird bei diesem Zustand das zuletzt eingestellte Übertragungsverhalten des Schattenfilters konstant gehalten, also keine Filterkoeffizienten übernommen.

Problematisch ist allerdings der Duplexbetrieb mit schmalbandigen Signalen, wie dies beispielsweise bei einer Datenübertragung mittels Modem der Fall ist. Einerseits ist eine Anpassung des adaptiven Filters bei schmalbandigen Signalen sehr schwierig und mit einem großen Fehler verbunden, andererseits erfolgt laufend eine Übernahme der fehlerhaften Koeffizienten des adaptiven Filters durch das Schattenfilter, da das Schattenfilter gegenüber dem adaptiven Filter zunächst einen größeren Fehler aufweist. Da jedoch das adaptive Filter und damit auch das Schattenfilter stark fehlerbehaftet sind, ist keine ausreichende Echounterdrückung möglich, was wiederum zu Störungen der Datenübertragung führen kann.

Aufgabe der Erfindung ist es, ein adaptive Balancefilter anzugeben, das diese Nachteile nicht aufweist.

Diese Aufgabe wird durch ein adaptives Balancefilter gemäß Patentanspruch 1 gelöst. Ausgestaltungen und Weiterbildungen des Erfindungsgedankens sind Gegenstand von Unteransprüchen.

Die Erfindung wird nachfolgend anhand des in der einzigen Figur der Zeichnung dargestellten Ausführungsbeispiels näher erläutert.

Ein erfindungsgemäßes adaptives Balancefilter enthält gemäß der Zeichnung einen Analog-Digital-Wandler ADC, an dessen Eingang ein mittels eines nicht näher dargestellten Empfangswegs übertragenes analoges Eingangssignal AI angelegt ist, und aus einem Digital-Analog-Umsetzer DAC, an dessen Eingang ein digitales Eingangssignal DI angelegt ist und dessen Ausgang ein analoges Ausgangssignal AO an einen nicht näher bezeichneten Sendeweg abgibt. Sowohl der Analog-Digital-Umsetzer ADC als auch der Digital-Analog-Umsetzer DAC enthält alle zur Signalwandlung notwendigen Einrichtungen, wie beispielsweise Antialiasing-Filter oder Einrichtungen zur Abtastratenerhöhung bzw. Erniedrigung. Der Echopfad zwischen dem Sendeweg und dem Empfangsweg kann dabei durch eine Übertragungsfunktion H(s) beschrieben werden.

An dem Ausgang des Analog-Digital-Umsetzers ADC ist zum einen der nicht invertierende Eingang eines Subtrahierers S1 direkt und zum anderen der nicht invertierende Eingang eines Subtrahierers S2 unter Zwischenschaltung eines Formfilters FO1 angeschlossen. Der invertierende Eingang des Substrahierers S1 ist mit dem Ausgang eines Schattenfilters FF mit einer Übertragungsfunktion Hₛ(z) und der invertierende Eingang des Subtrahierers S2 ist mit dem Ausgang eines adaptiven Filters BF mit der Übertragungsfunktion Hₐ(z) verbunden. Am Ausgang des Substrahierers S1 liegt ein digitales Ausgangssignal DO an.

Das digitale Eingangssignal DI ist außer an den Digital-Analog-Umsetzer DAC auch an die Eingänge des Schattenfilters FF, des adaptiven Filters BF und einer Filterbank FB geführt. Dabei ist zwischen den Eingängen des Schattenfilters FF, des adaptiven Filters BF und der Filterbank FB ein Fixfilter FX sowie den Eingängen des adaptiven Filters BF und der Filterbank FB zusätzlich ein weiteres zum Formfilter FO1 identisch ausgeführtes Formfilter FO2 vorgeschaltet.

Die Filterbank FB spaltet das an ihrem Eingang anliegende Signal, nämlich das über das Fixfilter FX und das Formfilter FO2 geführte digitale Eingangssignal DI, in drei bestimmten Frequenzbereichen zugeordnete Teilsignale auf. Dazu weist die Filterbank FB drei Bandpässe BP1 bis BP3 auf. Die Ausgänge der Filterbank FB entsprechen den Ausgängen der Bandpässe BP1 bis BP3 und sind jeweils mit einem Eingang einer Auswerteschaltung CC verbunden. Am Ausgang der Auswerteschaltung CC liegt beim Überschreiten bestimmter Mindestenergien in jedem der durch die Filterbank FB definierten Frequenzbereiche ein Steuersignal an. Dazu besteht die Auswerteschaltung CC beispielsweise aus drei Betragseinrichtungen AV1 bis AV3, die jeweils den Betrag der entsprechenden Ausgangssignale der Filter FB bilden, aus drei jeweils den Betragseinrichtungen AV1 bis AV3 nachgeschalteten Tiefpässen, aus den Tiefpässen LP1 bis LP3 nachgeschalteten Komparatoren C1 bis C3, die zudem jeweils mit gleichen oder unterschiedlichen Referenzwerten R1 bis R3 beaufschlagt sind, und mit einem UND-Gatter AG, daß die Ausgänge der Komparatoren C1 bis C3 miteinander verknüpft und an dessen Ausgang das Steuersignal anliegt. Das Steuersignal ist auf den Steuereingang einer zwischen Koeffizientenausgang des adaptiven Filters BF und Koeffizienteneingang des Schattenfilter FF geschalteten Transfereinrichtung GT geführt, wobei beim Auftreten des Steuersignals die Filterkoeffizienten des adaptiven Filters BF dem Schattenfilter FF übertragen werden.

Wesentlich an der Funktionsweise eines erfindungsgemäßen adaptiven Balancefilters ist, daß nur das digitale Eingangssignal DI ausgewertet wird, daß die Auswertung mindestens in drei Frequenzbereichen des digitalen Eingangssignals DI erfolgt und daß erst beim Auftreten bestimmter Mindestenergien in den einzelnen Frequenzbereichen eine Übergabe der Koeffizienten des adaptiven Filters BF an das Schattenfilter FF erfolgt. Nur in diesem Fall werden also die Daten des Schattenfilters FF erneuert. Ansonsten werden die Koeffizienten des Schattenfilters FF so lange konstant gehalten, bis wiederum ein breitbandiges digitales Eingangssignal DI anliegt.

In Ausgestaltung der Erfindung sind zudem das Fixfilter FX und die beiden Formfilter FO1 und FO2 vorgesehen. Das Formfilter FX realisiert dabei einem konstanten, d. h. in allen Adaptionsbereichen des adaptiven Filters BF und damit auch des Schattenfilters FF auftretenden Faktor der Übertragungsfunktion Hₐ(z) bzw. Hₛ(z), der also gesondert realisiert wird und damit den Aufwand für das adaptive Filter BF und das Schattenfilter FF verringert. Das Formfilter FO2 ist so ausgelegt, daß es das durchschnittliche Sprachspektrum dem Spektrum von weißem Rauschen annäherd, weist also im wesentlichen Hochpaßverhalten auf. Dadurch wird erreicht, daß eine gleichmäßigere Aussteuerung der einzelnen Frequenzbereichen zugeordneten Schaltungsteilen der Filterbank FB und der Auswerteschaltung CC gegeben ist. Das zum Formfilter FO2 identische Formfilter FO1 dient dazu, eine Gleichbewertung des Anteils des analogen Eingangssignals AI und des Anteils des über das adaptive Filter BF geführten digitalen Eingangssignals DI bei dem am Ausgang des Subtrahierers S2 anliegenden Fehlersignals für das adaptive Filter BF zu erzielen.

Die Aufteilung des digitalen Eingangssignals DI in einzelne Frequenzbereiche erfolgt mittels der Filterbank FB, die beispielsweise aus einer Anzahl von Bandpaßfiltern besteht, die wiederum als beliebige digitale Filter mit rekursiven und nichtrekursiven Strukturen, insbesondere aber als Wellenditialfilter, ausgeführt sind. Die Auswertung der Signalenergien in den einzelnen Frequenzbereichen durch die Auswerteschaltung CC ist unter anderem durch Betragsbildung mit anschließender Tiefpaßfilterung und Vergleich mit einen gegebenen Referenzwert durchzuführen. In gleicher Weise ist anstelle der Betragsbildung aber auch beispielsweise Quadrieren möglich. Die Referenzwerte werden dabei so eingestellt, daß eine Übernahme der Koeffizienten durch das Schattenfilter FF nur dann erfolgt, wenn die Energie in dem durch die Zeitkonstanten der Tiefpässe festgelegten Beobachtungszeitraum ausreichend war für ein exaktes Adaptieren des adaptiven Filters BF. Die Referenzwerte können dabei sowohl untereinanderverschieden als auch identisch sein und darüber hinaus konstant gehalten oder aber auch beispielsweise durch externe Programmierung veränderbar sein. Die Genauigkeit der Filterbank FB und der Auswerteschaltung CC kann durch Erhöhung der Zahl der Frequenzbereiche weiter erhöht werden, jedoch ist eine Aufteilung in drei Frequenzbereiche, also einem Bereich für tiefe, mittlere und höhere Frequenzen, für die meisten Anwendungen insbesondere im Fernsprechbereich vollkommen ausreichend. Ein erfindungsgemäßes adaptives Balancefilter ist damit in besonderem Maße sowohl für den Betrieb mit schmalbandigen Signalen als auch für Duplexbetrieb, und hierbei insbesondere mit schmalbandigen Signalen, geeignet.

Anschließend sei daraufhingewiesen, daß selbstverständlich bei Einspeisung eines weißem Rauschen entsprechenden Testsignals als digitalem Eingangssignal DI die beiden Formfilter FO1 und FO2 zu überbrücken sind.

## Patentansprüche

1. Adaptives Balancefilter
mit einem Digital-Analog-Umsetzer (DAC), an dessen Eingang ein digitales Eingangssignal (DI) angelegt ist und an dessen Ausgang ein analoges Ausgangssignal (AO) anliegt,
mit einer Filterbank, an deren Eingang das digitale Eingangssignal (DI) angelegt ist und die mehr als zwei jeweils einem Frequenzbereich zugeordnete Ausgänge aufweist,
mit einer Auswerteschaltung (CC), deren Eingänge jeweils mit einem Ausgang der Filterbank (FB) verbunden sind und an deren Ausgang beim Überschreiten bestimmter Mindestenergien in jedem Frequenzbereich ein Steuersignal anliegt,
mit einem adaptiven Filter (BF), das einen Signalausgang und einen Koeffizientenausgang zur Ausgabe seiner Filterkoeffizienten sowie einen Fehlersignaleingang und einen mit dem digitalen Eingangssignal (DI) belegten Signaleingang aufweist,
mit einem Schattenfilter (FF), an dessen Signaleingang das digitale Eingangssignal (DI) angelegt ist und das einen Signalausgang sowie einen Koeffizienteneingang zum Laden der Filterkoeffizienten aufweist,
mit einem Analog-Digital-Umsetzer (ADC), an dessen Eingang ein analoges Eingangssignal (AI) angelegt ist,
mit einem ersten Subtrahierer (S1), dessen nichtinvertierender Eingang mit dem Ausgang des Analog-Digital-Umsetzers (ADC) und dessen invertierender Eingang mit dem Signalausgang des Schattenfilters (FF) verbunden ist und an dessen Ausgang ein digitales Ausgangssignal (DO) anliegt,
mit einem zweiten Subtrahierer (S2), dessen nichtinvertierender Eingang mit dem Ausgang des Analog-Digital-Umsetzers (ADC),
dessen invertierender Eingang mit dem Signalausgang des adaptiven Filters (BF) und dessen Ausgang mit dem Fehlersignaleingang des adaptiven Filters (BF) verbunden ist und
mit einer Transfereinrichtung (GT), die zwischen Koeffizientenausgang des adaptiven Filters (BF) und Koeffizienteneingang des Schattenfilters (FF) geschaltet ist und deren Steuereingang mit dem Ausgang der Auswerteschaltng (CC) verbunden ist, wobei beim Auftreten eines entsprechenden Steuersignals am Steuereingang die Filterkoeffizienten des adaptiven Filters (BF) dem Schattenfilter (FF) übergeben werden.

2. Adaptives Balancefilter nach Anspruch 1,
**gekennzeichnet durch** ein Fixfilter (FX), das dem Schattenfilter (FF), dem adaptiven Filter (BF) und der Filterbank (FB) vorgeschaltet ist.

3. Adaptives Balancefilter nach Anspruch 1 oder 2,
**gekennzeichnet durch** ein erstes Formfilter (FO1), das dem nichtinvertierenden Eingang des zweiten Subtrahierers (S2) vorgeschaltet ist und durch ein zweites Formfilter (FO2), das ein zum ersten Formfilter identisches Übertragungsverhalten aufweist und das der Filterbank (FB) sowie dem adaptiven Filter (BF) vorgeschaltet ist.

4. Adaptives Balancefilter nach einem der Ansprüche 1 bis 3,
**dadurch gekennzeichnet,** daß die Auswerteschaltung (CC) jeweils den Eingängen zugeordnete Betragseinrichtungen (AV1, AV2, A3), denen jeweils ein Tiefpaßfilter LP1, LP2, LP3) und ein Komparator (C1, C2, C3) zum Vergleich mit jeweils einem Referenzwert (R1, R2, R3) nachgeschaltet sind, und ein UND-Gatter zur Verknüpfung der Ausgänge der Komparatoren (C1, C2, C3), an dessen das Steuersignal anliegt, enthält.

## Claims

1. Adaptive balance filter
having a digital to analogue converter (DAC) to whose input a digital input signal (DI) is applied and at whose output an analogue output signal (AO) is present,
having a filter bank to whose input the digital input signal (DI) is applied and which has more than two outputs which are each assigned to a frequency band,
having-an evaluation circuit (CC) whose inputs are each connected to one output of the filter bank (FB) and at whose output a control signal is present if specific minimum energies are exceeded in each frequency band,
having an adaptive filter (BF) which has one signal output and one coefficient output in order to output its filter coefficients, as well as one fault signal input and one signal input to which the digital input signal (DI) is applied,
having a shadow filter (FF) to whose signal input the digital input signal (DI) is applied and which has a signal output as well as a coefficient input for loading the filter coefficients,
having an analogue to digital converter (ADC) to whose input an analogue input signal (AI) is applied,
having a first subtractor (S1) whose non-inverting input is connected to the output of the analogue to digital converter (ADC) and whose inverting input is connected to the signal output of the shadow filter (FF) and at whose output the digital output signal (DO) is present,
having a second subtractor (S2) whose non-inverting input is connected to the output of the analogue to digital converter (ADC), whose inverting input is connected to the signal output of the adaptive filter (BF) and whose output is connected to the fault signal input of the adaptive filter (BF) and
having a transfer device (GT) which is connected between the coefficient output of the adaptive filter (BF) and the coefficient input of the shadow filter (FF) and whose control input is connected to the output of the evaluation circuit (CC), the filter coefficients of the adaptive filter (BF) being passed to the shadow filter (FF) when a corresponding control signal occurs at the control input.

2. Adaptive balance filter according to Claim 1, characterized by a fixed filter (FX) which is connected upstream of the shadow filter (FF), the adaptive filter (BF) and the filter bank (FB).

3. Adaptive balance filter according to Claim 1 or 2, characterized by a first form filter (FO1), which is connected upstream of the non-inverting input of the second subtractor (S2), and by a second form filter (FO2) which has a transfer function identical to the first form filter and is connected upstream of the filter bank (FB) as well as the adaptive filter (BF).

4. Adaptive balance filter according to one of Claims 1 to 3, characterized in that the evaluation circuit (CC) contains magnitude devices (AV1, AV2, AV3) which are each assigned to the inputs and downstream of which in each case one low-pass filter (LP1, LP2, LP3) and one comparator (C1, C2, C3) are connected for comparison with in each case one reference value (R1, R2, R3), and contains an AND gate for linking the outputs of the comparators (C1, C2, C3), at which the control signal is present.

## Revendications

1. Filtre d'équilibrage adaptatif, comportant
un convertisseur numérique/analogique (DAC), à l'entrée duquel est appliqué un signal d'entrée numérique (DI) et à la sortie duquel est délivré un signal de sortie analogique (AO),
un banc de filtre, à l'entrée duquel est appliqué le signal d'entrée numérique (DI) et qui comporte plus de deux sorties associées chacune à une gamme de fréquences,
un circuit d'évaluation (CC), dont les entrées sont reliées chacune à une sortie du banc de filtre (FB) et à la sortie duquel un signal de commande est appliqué, lors du dépassement d'énergies minimales déterminées dans chaque gamme de fréquences,
un filtre adaptatif (BF), qui comporte une sortie de signaux et une sortie de coefficients servant à délivrer ses coefficients de filtre, ainsi qu'une entrée de signal d'erreur et une entrée de signal occupée par le signal d'entrée numérique (DI),
un filtre d'écho (FF), à l'entrée de signal duquel est appliqué le signal d'entrée numérique (DI) et qui comporte une sortie des signaux ainsi qu'une entrée de coefficients pour le chargement des coefficients de filtre,
un convertisseur numérique/analogique (ADC), à l'entrée duquel est appliqué un signal d'entrée analogique (AI),
un premier soustracteur (S1), dont l'entrée non inverseuse est reliée à la sortie du convertisseur analogique/numérique (ADC) et dont l'entrée inverseuse est reliée à l'entrée des signaux du filtre d'écho (FF) et la sortie duquel est présent un signal de sortie numérique (DO),
un second soustracteur (S2), dont l'entrée non inverseuse est reliée à la sortie du convertisseur analogique/numérique (ADC), dont l'entrée inverseuse est reliée à l'entrée de signal du filtre adaptatif (BF) et dont la sortie est reliée à l'entrée du signal d'erreur du filtre adaptatif (BF), et
un dispositif de transfert (GT), qui est branché entre la sortie des coefficients du filtre adaptatif (BF) et l'entrée des coefficients du filtre d'écho (FF) et dont l'entrée de commande est reliée à la sortie du circuit d'évaluation (CC), les coefficients du filtre adaptatif (BF) étant transférés au filtre d'écho (FF) lors de l'apparition d'un signal de commande correspondant à l'entrée de commande.

2. Filtre d'équilibrage adaptatif suivant la revendication 1, caractérisé par un filtre à constante (FX), qui est branché en amont du filtre d'ombres (FF), du filtre adaptatif (BF) et du banc de filtre (FB).

3. Filtre d'équilibrage adaptatif suivant la revendication 1 ou 2, caractérisé par un premier filtre de forme (FO1), qui est branché en amont de l'entrée non inverseuse du second soustracteur (S2), et par un second filtre de forme (FO2), qui a un comportement de transmission identique au premier filtre de forme et qui est branché en amont du banc de filtre (FB) ainsi que du filtre adaptatif (BF).

4. Filtre d'équilibrage adaptatif suivant l'une des revendications 1 à 3 caractérisé par le fait que le circuit d'évaluation (CC) contient des dispositifs (AV1,AV2,AV3) de formation de valeurs absolues, qui sont associés aux entrées et en aval desquels sont branchés respectivement un filtre passe-bas (LP1,LP2,LP3) et un comparateur (C1,C2,C3) destiné à la comparaison à une valeur de référence (R1,R2,R3), et une porte ET destinée à la combinaison des sorties des comparateurs (C1,C2,C3), auxquelles est appliqué le signal de commande.
